(19) Europäisches Patentamt
European Patent Office
Office européen des brevets

(11) **EP 2 994 420 B1**

(12) **EUROPÄISCHE PATENTSCHRIFT**

(45) Veröffentlichungstag und Bekanntmachung des Hinweises auf die Patenterteilung:
**22.03.2017  Patentblatt 2017/12**

(21) Anmeldenummer: **14721307.8**

(22) Anmeldetag: **28.04.2014**

(51) Int Cl.:
**C01B 33/021** $^{(2006.01)}$

(86) Internationale Anmeldenummer:
**PCT/EP2014/058588**

(87) Internationale Veröffentlichungsnummer:
**WO 2014/180693 (13.11.2014 Gazette 2014/46)**

(54) **WIRBELSCHICHTREAKTOR UND VERFAHREN ZUR HERSTELLUNG VON GRANULAREM POLYSILICIUM**

FLUIDIZED BED REACTOR AND METHOD OF PRODUCING GRANULAR POLYSILICON

RÉACTEUR À LIT FLUIDISÉ ET PROCÉDÉ DE PRODUCTION DE POLYSILICIUM GRANULAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.05.2013  DE 102013208274**

(43) Veröffentlichungstag der Anmeldung:
**16.03.2016  Patentblatt 2016/11**

(73) Patentinhaber: **Wacker Chemie AG**
**81737 München (DE)**

(72) Erfinder:
• **PEDRON, Simon**
**84489 Burghausen (DE)**

• **FORSTPOINTNER, Gerhard**
**84556 Kastl (DE)**

(74) Vertreter: **Potten, Holger et al**
**Wacker Chemie AG**
**Zentralbereich Patente, Marken und Lizenzen**
**Hanns-Seidel-Platz 4**
**81737 München (DE)**

(56) Entgegenhaltungen:
**EP-A1- 0 896 952      EP-A1- 1 205 435**
**DE-A1- 19 722 570      DE-C- 752 280**

EP 2 994 420 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Wirbelschichtreaktor und ein Verfahren zur Herstellung von granularem Polysilicium.

Polykristallines Siliciumgranulat oder kurz Polysilicium-Granulat ist eine Alternative zum im Siemens-Verfahren hergestellten Polysilicium. Während das Polysilicium im Siemens-Verfahren als zylindrischer Siliciumstab anfällt, der vor seiner Weiterverarbeitung zeit- und kostenaufwändig zu so genanntem Chippoly zerkleinert und ggf. wiederum gereinigt werden muss, besitzt Polysilicium-Granulat Schüttguteigenschaften und kann direkt als Rohmaterial z. B. zur Einkristallerzeugung für die Photovoltaik- und Elektronikindustrie eingesetzt werden.

Polysilicium-Granulat wird in einem Wirbelschichtreaktor produziert. Dies geschieht durch Fluidisierung von Siliciumpartikeln mittels einer Gasströmung in einer Wirbelschicht, wobei diese über eine Heizvorrichtung auf hohe Temperaturen aufgeheizt wird. Durch Zugabe eines siliciumhaltigen Reaktionsgases erfolgt eine Pyrolysereaktion an der heißen Partikeloberfläche. Dabei scheidet sich elementares Silicium auf den Siliciumpartikeln ab und die einzelnen Partikel wachsen im Durchmesser an. Durch den regelmäßigen Abzug von angewachsenen Partikeln und Zugabe kleinerer Siliciumpartikel als Keimpartikel (im weiteren Verlauf des Dokuments "send" genannt) kann das Verfahren kontinuierlich mit allen damit verbundenen Vorteilen betrieben werden. Als siliciumhaltiges Eduktgas sind Silicium-Halogenverbindungen (z. B. Chlorsilane oder Bromsilane), Monosilan ($SiH_4$), sowie Mischungen dieser Gase mit Wasserstoff oder anderen Inertgasen, beispielsweise Stickstoff, beschrieben. Derartige Abscheideverfahren und Vorrichtungen hierzu sind beispielsweise aus US 4786477 A bekannt.

US 7922990 B2 beschreibt einen Fließbettreaktor, der aufweist: eine drucktragende Hülle, ein inneres Reaktorrohr aus einem Material, das eine hohe Transmission für Temperaturstrahlung aufweist, einen Einlass für Siliciumpartikel, eine Einlassvorrichtung zum Zuführen eines Reaktionsgases, das eine gas- oder dampfförmige Siliciumverbindung enthält, eine Gasverteilungseinrichtung für die Zufuhr eines Fluidisiergases, einen Auslass für nicht abreagiertes Reaktionsgas, Fluidisiergas sowie die gas- oder dampfförmigen Produkte der Reaktion, welche sich oberhalb der Wirbelbettoberfläche sammeln, einen Auslass für das Produkt, eine Heizvorrichtung und eine Energieversorgung für die Heizvorrichtung. Beispielsweise wird offenbart, dass sich in einem druckfesten Stahlbehälter mit einem Innendurchmesser von 770 mm das innere Reaktorrohr, ein Quarzrohr von 600 mm Innendurchmesser und 2200 mm Länge, befindet. Am unteren Ende des Quarzrohres bildet eine mit Öffnungen versehene Platte aus Quarz den Gasverteiler für das Fluidisiergas. In einem Zentrumskreis angeordnet mit einem Durchmesser von 250 mm ragen aus der Gasverteilerplatte in das innere Reaktorrohr 4 weitere Quarzrohre mit 20 mm Innendurchmesser und 250 mm Länge als Einlassvorrichtung für die Zufuhr des siliciumhaltigen Gases bzw. Gasgemisches. Weiterhin ist die Quarzplatte mit zwei Öffnungen zur Entnahme von Produkt versehen.

US 2008/0299291 A1 offenbart ein Verfahren zur Herstellung von hochreinem Polysiliciumgranulat durch Abscheidung eines Reaktionsgases an Siliciumgranulat in einem Wirbelschichtreaktor. Das Reaktionsgas wird dabei als ein oder mehrere vertikal nach oben gerichtete Gasstrahlen in die mittels Verdünnungsgas schwach fluidisierte Wirbelschicht eingedüst und zwar in einer Art und Weise, dass sich oberhalb der Zuführdüsen innerhalb der Wirbelschicht eine oder mehrere lokale Reaktionsbereiche ausbilden, in denen das Reaktionsgas nahezu vollständig bis zum chemischen Gleichgewicht reagiert, bevor es die Wirbelschichtbewandung oder die Wirbelschichtoberfläche erreicht. Bevorzugt wird das Verdünnungsgas über mehrere, möglichst gleichmäßig über den Querschnitt der Wirbelschicht verteilte Einzeldüsen zugeführt. Dadurch wird in diesem schwach fluidisierten Bereich ein hohes Maß an Turbulenz erzeugt, wodurch effektiv die Bildung von Agglomeraten verhindert werden kann. Dies ist insbesondere deshalb wichtig, weil aus diesem Bereich auch das abgeschiedene Produktgranulat aus der Wirbelschicht abgezogen wird. Das Verdünnungsgas wird über Einzeldüsen in die untere Zone der Wirbelschicht geführt, wobei sich an jeder Düse ein lokaler Strahlbereich bildet. Diese Einzelstrahlen lösen sich nach oben hin zu einer blasenbildenden Wirbelschicht auf. Das Reaktionsgas wird über eine oder mehrere Reaktionsgaszuführungen durch den Reaktorboden in den Reaktor geführt und strömt in definierter Höhe über dem Niveau der Verdünnungsgasdüsen in die Wirbelschicht. Dadurch bildet sich zwischen dem Gasaustritt des Reaktionsgases und dem Gasaustritt aus den Verdünnungsgasdüsen ein Wirbelschichtbereich, der nur von Verdünnungsgas durchströmt wird. Auch die Verdünnungsgasdüsen und die Reaktionsgaszuführungen sind aus einem möglichst reinen Werkstoff gefertigt, der das Siliciumgranulat möglichst gering kontaminiert, bevorzugt aus hochreinem Quarz. Die Reaktionsgaszuführungen bestehen jeweils aus einer zentralen Reaktionsgasdüse und einer, diese umschließenden, Ringdüse, so dass sich ein Ringspalt für die Zuführung von Verdünnungsgas bildet.

Bei den eingangs erwähnten Vorrichtungen und Verfahren hat sich gezeigt, dass zeitlich schwankende Druckverhältnisse in Wirbelschichten Schwankungen der zugeführten Gasmassenströme verursachen. Dies führt zu Instabilitäten im chemischen Prozess und in der Temperaturverteilung. Auch lokal aussetzende Fluidisierung wurde beobachtet, und damit beispielsweise Sinterungen an heißen Oberflächen. Lokal schwankende Druckverhältnisse in der Wirbelschicht sind gleichwirkend, insbesondere wenn Gasmassenströme durch mehrere über den Querschnitt verteilte Öffnungen wie z.B. Düsen zugeführt werden.

Aus konstruktiven, prozessbedingten und Qualitätsgründen kann bei der Siliciumabscheidung mit Silanen (SiH$_n$XI$_{4-n}$ mit X = Halogen, z.B. F, Cl, I; n = 0-4) in einem Wirbelschichtreaktor kein konventioneller Gasverteilerboden eingesetzt werden, über den alle Gasmassenströme zugeführt werden können. Die Öffnungen, über die die Gase der Wirbelschicht zugeführt werden, weisen einen für eine zeitliche und lokale Gleichverteilung der jeweiligen Massenströme nicht ausreichenden Druckverlust auf.

US 7490785 B2 offenbart eine Vorrichtung zur Herstellung von Siliciumkeimpartikeln aus einem Siliciumgranulat umfassend eine vertikal angeordnete Strahlkammer mit einem zylindrischen Querschnitt mit einer Strahldüse am Boden der Strahlkammer, durch die ein Mahlgasstrom in die Strahlkammer eingebracht werden kann, einen direkt an die Strahlkammer sich anschliessenden Gegenstrom-Schwerkraftsichter und einen Einlass für ein Siliciumgranulat, dadurch gekennzeichnet, dass die Strahlkammer eine Länge hat, die für eine Aufweitung des Mahlgastromes auf den Querschnitt der Strahlkammer ausreicht und die Strahlkammer einen kleineren Strömungsquerschnitt hat als der Gegenstrom-Schwerkraftsichter. Bevorzugt handelt es sich um eine Wirbelschicht-Strahlmühle. Dabei erfolgt die Zufuhr des Mahlgases über eine Strahldüse, ausgeführt als einfache Düse oder als Laval-Düse, die am Boden der Mahlkammer angeordnet ist. Das Aufgabegut wird seitlich über einen Einlass der Mahlkammer zugeführt. In der Mahlkammer bildet sich aus Mahlgas und Partikeln eine Wirbelschicht, in der die durch den Gasstrahl beschleunigten Partikel mit anderen Partikeln kollidieren und zerbrechen.

US 7850102 B2 offenbart ein Verfahren zur Vermahlung amorpher Feststoffe mittels eines Mahlsystems (Mahlapparatur), bevorzugt eines Mahlsystems umfassend eine Strahlmühle, dadurch gekennzeichnet, dass die Mühle in der Mahlphase mit einem Betriebsmittel, ausgewählt aus der Gruppe, die aus Gas und/oder Dampf, bevorzugt Wasserdampf, und/oder einem Gas enthaltend Wasserdampf, besteht, betrieben wird und dass der Mahlraum in einer Aufheizphase, d. h. vor dem eigentlichen Betrieb mit dem Betriebsmittel, derart aufgeheizt wird, dass die Temperatur im Mahlraum und/oder am Mühlenausgang, höher liegt als der Taupunkt des Dampfes und/oder des Betriebsmittels. Das Verfahren wird in einem Mahlsystem (Mahlapparatur), bevorzugt in einem Mahlsystem umfassend eine Strahlmühle, besonders bevorzugt umfassend eine Gegenstrahlmühle ausgeführt. Dazu wird ein zu zerkleinerndes Aufgabegut in expandierenden Gasstrahlen hoher Geschwindigkeit beschleunigt und durch Partikel-Partikel-Stösse zerkleinert. Als Strahlmühlen werden ganz besonders bevorzugt Fließbettgegenstrahlmühlen oder Dichtbettstrahlmühlen oder Spiralstrahlmühlen verwendet. Im Falle der ganz besonders bevorzugten Fließbettgegenstrahlmühle befinden sich im unteren Drittel der Mahlkammer zwei oder mehr Mahlstrahleinlässe, bevorzugt in Form von Mahldüsen, welche sich bevorzugt in einer horizontalen Ebene befinden. Als Mahldüsen können Lavaldüsen zum Einsatz kommen.

Der Einsatz von Lavaldüsen in Zusammenhang mit Wirbelschicht-Strahlmühlen zur Herstellung von Keimpartikeln für die Abscheidung von polykristallinem Siliciumgranulat durch Mahlung von Siliciumgranulat ist also im Stand der Technik bereits bekannt. Eine Lavaldüse ist ein Strömungsorgan mit einem zunächst konvergenten und anschließenden divergenten Querschnitt, wobei der Übergang von einem zum anderen Teil allmählich erfolgt. Die Querschnittsfläche an jeder Stelle sei kreisförmig, wodurch ein durchströmendes Fluid auf Überschallgeschwindigkeit beschleunigt werden kann, ohne dass es zu starken Verdichtungsstößen kommt. Die Schallgeschwindigkeit wird genau im engsten Querschnitt der Düse erreicht.

Aus der zuvor beschriebenen Problematik der zeitlich und/oder lokal schwankenden Druckverhältnisse in den Wirbelschichten bei der Herstellung von polykristallinem Siliciumgranulat ergab sich die Aufgabenstellung der Erfindung.

Die Aufgabe der Erfindung wird gelöst durch einen Wirbelschichtreaktor zur Herstellung von granularem Polysilicium, umfassend einen Behälter mit einem Innen-Reaktorrohr für eine Wirbelschicht mit granularem Polysilicium und einen Reaktorboden, eine Heizvorrichtung zum Heizen der Wirbelschicht im Innen-Reaktorrohr, wenigstens eine Öffnung im Reaktorboden zur Zuführung von Fluidisierungsgas sowie wenigstens eine Öffnung im Reaktorboden zur Zuführung von Reaktionsgas, eine Vorrichtung zum Abführen von Reaktorabgas, eine Zuführeinrichtung, um Siliciumpartikel zuzuführen sowie eine Entnahmeleitung für granulares Polysilicium, wobei wenigstens einer der Öffnungen im Reaktorboden außerhalb des Innenreaktorrohrs eine Lavaldüse vorgelagert ist, geeignet, um wenigstens einen zugeführten Massenstrom überkritisch zu expandieren.

Vorzugsweise umfasst der Wirbelschichtreaktor wenigstens zwei Öffnungen im Reaktorboden mit jeweils vorgelagerter Lavaldüse.

Vorzugsweise umfasst der Wirbelschichtreaktor wenigstens eine Gruppe von Öffnungen im Reaktorboden, umfassend wenigstens zwei Öffnungen, wobei der wenigstens einen Gruppe von Öffnungen jeweils eine Lavaldüse vorgelagert ist.

Vorzugsweise umfasst der Wirbelschichtreaktor wenigstens eine Gruppe von Öffnungen im Reaktorboden, umfassend jeweils wenigstens zwei Öffnungen, wobei jeder Öffnung jeweils eine Lavaldüse vorgelagert ist, sodass wenigstens eine Gruppe von Lavaldüsen, umfassend jeweils wenigstens zwei Lavaldüsen, resultiert, wobei jener wenigstens einen Gruppe von Lavaldüsen jeweils eine Lavaldüse vorgeschaltet.

Vorzugsweise handelt es sich bei der wenigstens einen Öffnung im Reaktorboden, der eine Lavaldüse vorgelagert ist, um eine Gasverteilervorrichtung.

Vorzugsweise handelt es sich bei der wenigstens einen Öffnung im Reaktorboden, der eine Lavaldüse vorgelagert ist, um ein Loch in der Bodenplatte, um ein Ventil oder um eine Düse.

Die Aufgabe wird auch gelöst durch ein Verfahren zur Herstellung von granularem Polysilicium in einer erfindungsgemäßen Vorrichtung oder in einer Vorrichtung gemäß einer der zuvor genannten bevorzugten Ausführungen, umfassend Fluidisierung von Siliciumpartikeln mittels eines Fluidisierungsgases in einer Wirbelschicht, die über eine Heizvorrichtung auf eine Temperatur von 850- 1200°C aufgeheizt wird, Zugabe eines siliciumhaltigen Reaktionsgases und Abscheidung von Silicium auf den Siliciumpartikeln.

Die Erfindung betrifft auch ein Verfahren zur Herstellung von granularem Polysilicium in einem Wirbelschichtreaktor, umfassend Fluidisierung von Siliciumpartikeln mittels eines über wenigstens eine Öffnung im Reaktorboden des Wirbelschichtreaktors zugeführten Fluidisierungsgases in einer Wirbelschicht, die über eine Heizvorrichtung auf eine Temperatur von 850-1200°C aufgeheizt wird, Zugabe eines siliciumhaltigen Reaktionsgases, das über wenigstens eine Öffnung im Reaktoroden des Wirbelschichtreaktors zugeführt wird, und Abscheidung von Silicium auf den Siliciumpartikeln, wobei wenigstens ein zugeführter Massenstrom von Fluidisierungsgas oder Reaktionsgas überkritisch expandiert wird.

Beim Fluidisierungsgas handelt es sich vorzugsweise um $H_2$ und beim siliciumhaltigen Reaktionsgas vorzugsweise um TCS.

Wenigstens einer der Öffnungen im Reaktorboden ist eine Lavaldüse vorgelagert, um den wenigstens einen zugeführten Massenstrom überkritisch zu expandieren, indem in der Lavaldüse Überdruck herrscht.

Zur Gleichverteilung von Gasmassenströmen in Wirbelschichten können auch Lochplatten mit Düsengeometrien, Düsenböden, Ventilböden oder vereinzelt porösen Platten mit einem definierten Druckverlust verwendet werden. Durch den Druckverlust des Gasverteilers werden die durch Druckschwankungen der Wirbelschicht induzierten Druck- und Massenstromschwankungen auf der Versorgungsseite stark gedämpft. Des Weiteren können Lochblenden in den Gaszufuhrleitungen eingesetzt werden, falls der Druckverlust der Gaseintrittsöffnungen nicht ausreicht.

Eine Gleichverteilung eines oder mehrerer einer Wirbelschicht zugeführter Gasmassenströme über die Zeit und alle Eintrittsöffnungen wird bei der vorliegenden Erfindung nicht durch einen Gasverteilerboden allein durch dessen Druckverlust sichergestellt, sondern über Lavaldüsen, welche vorzugsweise bei einem überkritischem Druckverhältnis betrieben werden.

Bei bestimmten Wirbelschichtanwendungen ist es auf Grund konstruktiver, prozessbedingter oder aus Qualitätsgründen nicht möglich, den benötigten Druckverlust zur Gasgleichverteilung über die Gasverteilerplatte bzw. die verwendeten Ventile oder Düsen sicherzustellen.

Vorgelagerte Lavaldüsen haben den Vorteil, dass sie für solche Anwendungen zur zeitlichen und örtlichen Vergleichmäßigung der zugeführten Gasmassenströme genutzt werden können, ohne in die Wirbelschichtapparate-, Gasverteilerplatten-, Düsen- oder Ventilgeometrie einzugreifen.

Die Gleichverteilung mindestens eines der der Wirbelschicht zugeführten Gasmassenströme erfolgt durch eine vorgelagerte Lavaldüse.

In Lavaldüsen wird durch Querschnittsverengung und anschließender Erweiterung ein definierter Druckverlust erzeugt. Erhöht sich die Druckdifferenz zwischen Eintritts- und Austrittsseite über ein gewisses Verhältnis hinaus (kritisches Druckverhältnis), so wird das Fluid in der Lavaldüse auf Schallgeschwindigkeit im engsten Querschnitt und Überschallgeschwindigkeit auf der Austrittsseite beschleunigt. Bei überkritischer Strömung bleibt der Massenstrom bei gleichbleibendem Düsenvordruck konstant, d.h. Druckschwankungen auf der Austrittsseite der Lavaldüse, welche mit dem Wirbelschichtapparat gekoppelt sind, haben keinen Einfluss auf den durchlaufenden Massenstrom.

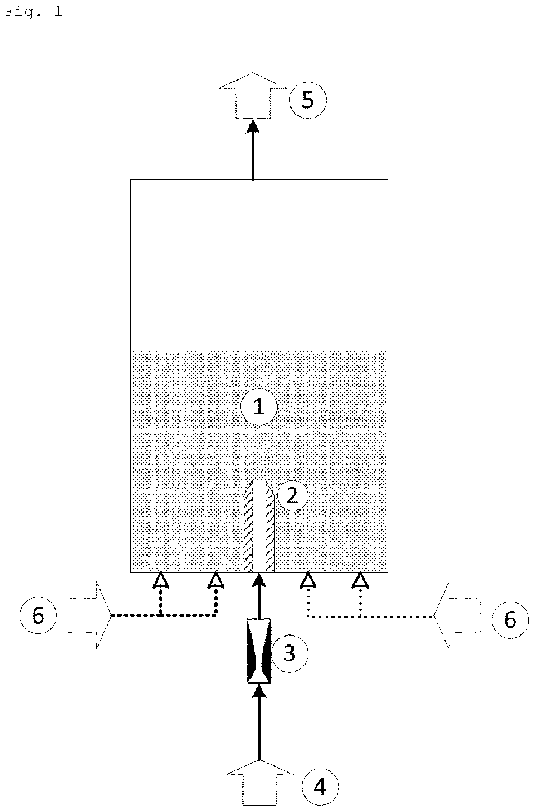

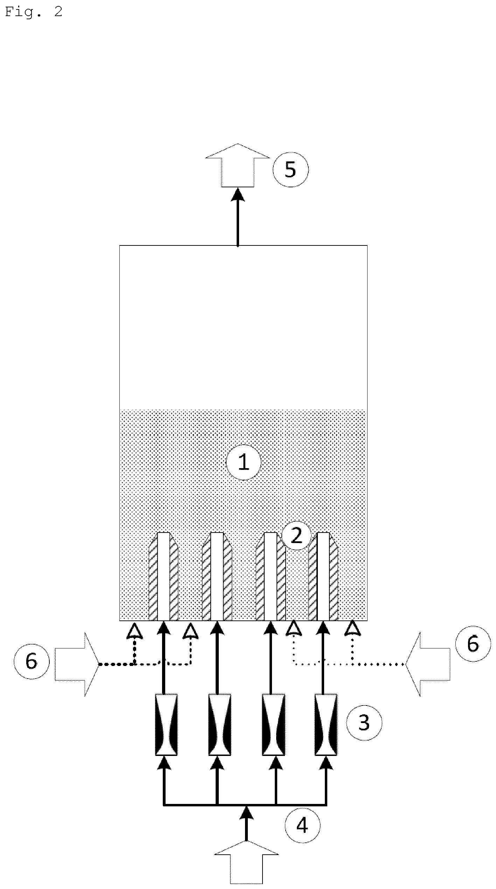

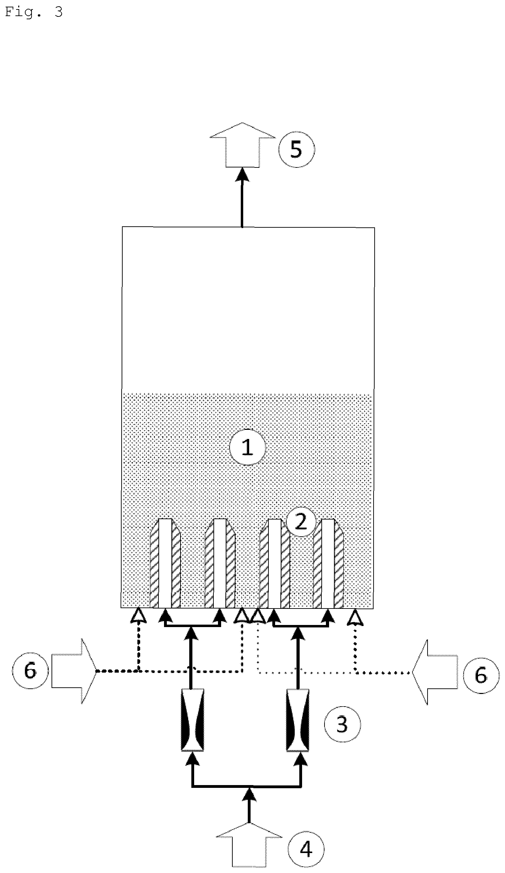

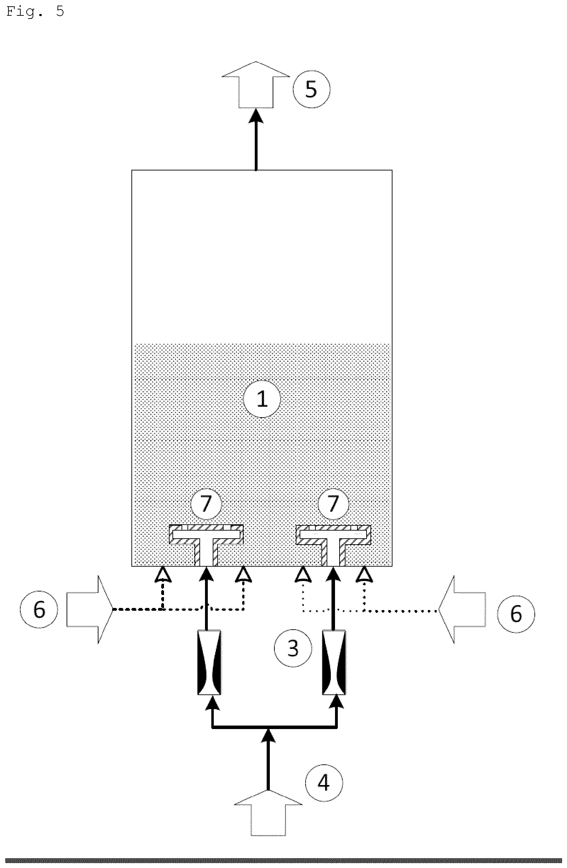

Bei der Anordnung der Lavaldüsen und Öffnungen (beispielsweise Löcher in der Bodenplatte, Ventile oder Düsen) ergeben sich verschiedene Möglichkeiten, die nachfolgende anhand der **Fig. 1-5** veranschaulicht werden.

## Liste der verwendeten Bezugszeichen

    **1** Wirbelschicht
    **2** Öffnung zur Zufuhr eines Gasmassenstroms in die Wirbelschicht
    **3** Lavaldüse
    **4** Zugas-Massenstrom
    **5** Abgas-Massenstrom

**6** Andere zugeführte Gasmassenströme

**7** Gasverteilerast(mit mehreren Öffnungen)

**Fig. 1** zeigt eine Ausführungsform mit einer Öffnung und vorgelagerter Lavaldüse.

**Fig. 2** zeigt eine Ausführungsform mit zwei oder mehr Öffnungen mit jeweils vorgelagerter Lavaldüse.

**Fig. 3** zeigt eine Ausführungsform mit ein oder mehreren Gruppen von Öffnungen, wovon jede Gruppe mindestens zwei Öffnungen aufweist. Jeder Gruppe ist eine Lavaldüse vorgelagert.

**Fig. 4** zeigt eine Ausführungsform mit zwei oder mehr Öffnungen, wobei jeder Öffnung eine Lavaldüse vorgelagert ist und welche zu einem oder mehreren Gruppen mit jeweils vorgelagerten Lavaldüsen zusammengefasst sind.

**Fig. 5** zeigt eine Ausführungsform mit ein oder mehreren Gasverteilervorrichtungen mit jeweils zwei oder mehr Öffnungen. Jeder Gasverteilervorrichtung ist eine Lavaldüse vorgelagert.

**Beispiele**

Die nachfolgenden Beispiele zeigen, dass der die Lavaldüsen durchströmende Gasmassenstrom vom Eintrittsdruck, dem Düsendurchmesser, der Gaszusammensetzung, der Temperatur und der Anzahl der Düsen abhängig ist.
Der Druck p_aus ist vorzugsweise so zu wählen, dass überkritischer Zustand in der Lavaldüse herrscht:

$$\left(\frac{p_{aus}}{p_{ein}}\right) < \left(\frac{p_{aus}}{p_{ein}}\right)_{krit}$$

Das kritische Druckverhältnis lässt sich wie folgt berechnen

$$\left(\frac{p_{aus}}{p_{ein}}\right)_{krit} = \left(\frac{2}{\kappa+1}\right)^{\frac{\kappa}{\kappa-1}}$$

Dabei ist $\kappa$ der Isentropenkoeffizient des durchströmenden Gases.
Der Massenstrom, der eine Öffnung mit der engsten freien Querschnittsflache A durchströmt, lässt sich wie folgt berechnen:

$$\dot{m} = A \cdot \sqrt{2 \cdot p_{ein} \cdot \rho_{ein}} \cdot \left(\frac{2}{\kappa+1}\right)^{\left(\frac{1}{\kappa-1}\right)} \cdot \sqrt{\frac{\kappa}{\kappa+1}}$$

$\rho_{ein}$ ist dabei die Dichte des Gases auf der Gaseintrittsseite (Druckseite).
**Beispiel 1** stellt den Referenzfall dar. Die Parameter des Referenzfalls sowie der weiteren Beispiele sind der **Tabelle 1** zu entnehmen.
In **Beispiel 2** wurde der Düsenquerschnitt erhöht.
Ein größerer Düsenquerschnitt bei gleichem Vordruck bedeutet mehr durchgefahrenen Massenstrom, was sich jedoch nicht auf p_aus auswirkt.
In **Beispiel 3** wurde die Gaszusammensetzung durch die Lavaldüse geändert. Es ergibt sich, dass der Massenstrom stark von der Gaszusammensetzung abhängt, wobei Gase mit kleiner Molmasse einen niedrigeren Druck hinter der Lavaldüse benötigen und ein kleinerer Massenstrom durchgefahren werden kann.
In **Beispiel 4** wurde eine Erhöhung der Temperatur vorgenommen. Dies bedingt eine Verringerung der Gasdichte und verringert damit ebenfalls den Massenstrom.
Auch eine Absenkung des Vordrucks der Lavaldüse führt dazu, dass weniger Gasmassenstrom die Düse durchströmen kann.

**Tabelle 1**

|  | Beispiel 1 | Beispiel 2 | Beispiel 3 | Beispiel 4 | Beispiel 5 |
|---|---|---|---|---|---|
| kleinster Durchmesser Lavaldüse [m] | 0,01 | **0,024** | 0,01 | 0,01 | 0,01 |
| x H$_2$ [mol%] | 50 | 50 | **95** | 50 | 50 |
| x HCl [mol%] | 0 | 0 | **5** | 0 | 0 |
| x TCS [mol%] | 50 | 50 | **0** | 50 | 50 |
| T ein [K] | 500 | 500 | 500 | **900** | 500 |
| (p_aus/p_ein)_krit [-] | 0,572 | 0,572 | 0,529 | 0,575 | 0,572 |
| p ein [bar] | 10,00 | 10,00 | 10,00 | 10,00 | **5,00** |
| p aus [bar] | <5, 72 | <5,725 | <5, 29 | <5, 75 | <2,86 |
| Massenstrom durch_einzelne Düse [kg/h] | 701 | 4036 | 174 | 520 | 350 |
| n Düsen | 3 | 3 | 3 | 3 | 3 |
| Gesamtmassenstrom | 2103 | 12108 | 522 | 1560 | 1050 |

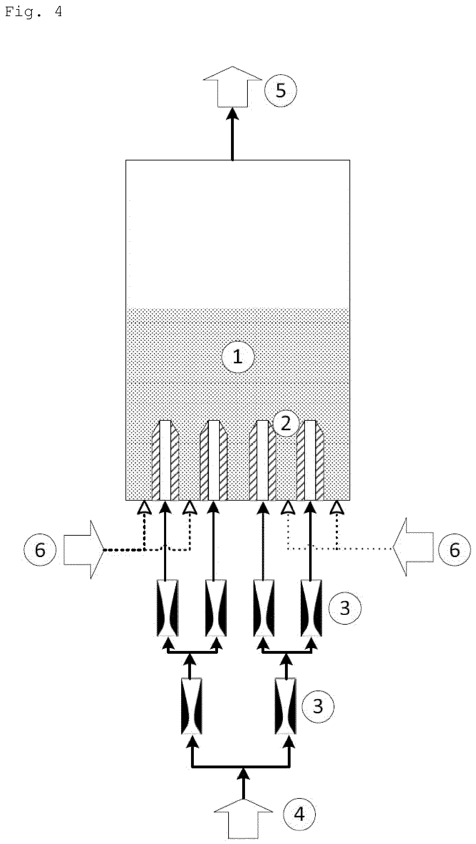

**Beispiel 6** lehnt sich an die Anordnung aus **Fig. 4** an, bei der vier Öffnungen über jeweils eine Lavaldüse verfügen, jeweils zwei Lavaldüsen zu einer Gruppe zusammengefasst sind und jeder Gruppe noch zusätzlich eine Lavaldüse vorgeschaltet ist.

Es ergeben sich die in **Tabelle 2** dargestellten Druckverhältnisse und Geometrien.

**Tabelle 2**

|  | Beispiel 6 |
|---|---|
| kleinster Durchmesser Lavaldüse vor Gruppe [m] | 0,01 |
| kleinster Durchmesser Lavaldüse vor Öffnung [m] | 0,0092 |
| x_H$_2$ [mol%] | 50 |
| x_HCl [mol%] | 0 |
| x_TCS [mol%] | 50 |
| T_ein [K] | 500 |
| p_ein [bar] | 15 |
| p_Mitte [bar] | <8,572 |
| p_aus [bar] | <4,889 |
| Massenstrom gesamt [kg/h] | 2102 |
| Massenstrom pro Gruppe [kg/h] | 1051 |
| Massenstrom pro _Öffnung [kg/h] | 525 |

**Patentansprüche**

1.  Wirbelschichtreaktor zur Herstellung von granularem Polysilicium, umfassend einen Behälter mit einem Innen-Reaktorrohr für eine Wirbelschicht (1) mit granularem Polysilicium und einen Reaktorboden, eine Heizvorrichtung zum Heizen der Wirbelschicht im Innen-Reaktorrohr, wenigstens eine Öffnung im Reaktorboden zur Zuführung von Fluidisierungsgas sowie wenigstens eine Öffnung (2) im Reaktorboden zur Zuführung von Reaktionsgas, eine Vorrichtung zum Abführen von Reaktorabgas, eine Zuführeinrichtung, um Siliciumpartikel zuzuführen sowie eine Entnahmeleitung für granulares Polysilicium, wobei wenigstens einer der Öffnungen im Reaktorboden außerhalb des Innenreaktorrohrs eine Lavaldüse (3) vorgelagert ist, geeignet, um wenigstens einen zugeführten Massenstrom (4) überkritisch zu expandieren.

**2.** Wirbelschichtreaktor nach Anspruch 1, umfassend wenigsten zwei Öffnungen (2) im Reaktorboden mit jeweils vorgelagerter Lavaldüse (3).

**3.** Wirbelschichtreaktor nach Anspruch 1, umfassend wenigstens eine Gruppe von Öffnungen (2) im Reaktorboden, umfassend wenigstens zwei Öffnungen (2), wobei der wenigstens einen Gruppe von Öffnungen (2) jeweils eine Lavaldüse (3) vorgelagert ist.

**4.** Wirbelschichtreaktor nach Anspruch 1, umfassend wenigstens eine Gruppe von Öffnungen (2) im Reaktorboden, umfassend jeweils wenigstens zwei Öffnungen (2), wobei jeder Öffnung (2) jeweils eine Lavaldüse (3) vorgelagert ist, so dass wenigstens eine Gruppe von Lavaldüsen (3), umfassend jeweils wenigstens zwei Lavaldüsen (3), resultiert, wobei jener wenigstens einen Gruppe von Lavaldüsen (3) jeweils eine Lavaldüse (3) vorgeschaltet ist.

**5.** Wirbelschichtreaktor nach Anspruch 1, wobei es sich bei der wenigstens einen Öffnung (2) im Reaktorboden, der eine Lavaldüse (3) vorgelagert ist, um eine Gasverteilervorrichtung (7) handelt.

**6.** Wirbelschichtreaktor nach einem der Ansprüche 1 bis 5, wobei es sich bei der wenigstens einen Öffnung (2) im Reaktorboden, der eine Lavaldüse (3) vorgelagert ist, um ein Loch in der Bodenplatte, um ein Ventil oder um eine Düse handelt.

**7.** Verfahren zur Herstellung von granularem Polysilicium in einem Wirbelschichtreaktor, umfassend Fluidisierung von Siliciumpartikeln mittels eines über wenigstens eine Öffnung im Reaktorboden des Wirbelschichtreaktors zugeführten Fluidisierungsgases in einer Wirbelschicht (1), die über eine Heizvorrichtung auf eine Temperatur von 850-1200°C aufgeheizt wird, Zugabe eines siliciumhaltigen Reaktionsgases, das über wenigstens eine Öffnung (2) im Reaktorboden des Wirbelschichtreaktors zugeführt wird, und Abscheidung von Silicium auf den Siliciumpartikeln, wobei wenigstens ein zugeführter Massenstrom (4) von Fluidisierungsgas oder Reaktionsgas überkritisch expandiert wird, wobei wenigstens einer der Öffnungen (2) im Reaktorboden eine Lavaldüse (3) vorgelagert ist, um den wenigstens einen zugeführten Massenstrom (4) überkritisch zu expandieren, indem in der Lavaldüse (3) Überdruck herrscht.

**8.** Verfahren nach Anspruch 7, wobei es sich beim Fluidisierungsgas um $H_2$ und beim siliciumhaltigen Reaktionsgas um TCS handelt.

**9.** Verfahren nach einem der Ansprüche 7 oder 8, wobei ein Wirbelschichtreaktor nach einem der Ansprüche 1 bis 6 eingesetzt wird.

**Claims**

**1.** Fluidized bed reactor for producing granular polysilicon, which comprises a vessel having an inner reactor tube for a fluidized bed (1) with granular polysilicon and a reactor base, a heating device for heating the fluidized bed in the inner reactor tube, at least one opening in the reactor base for feeding fluidizing gas, and at least one opening (2) in the reactor base for feeding reaction gas, a device for removing reactor offgas, a feed appliance for feeding silicon particles, and also a withdrawal conduit for granular polysilicon, wherein a Laval nozzle (3) is situated upstream of at least one of the openings in the reactor base outside the inner reactor tube, suitable for expanding supercritically at least one mass stream (4) that is fed.

**2.** Fluidized bed reactor according to Claim 1, comprising at least two openings (2) in the reactor base each having a Laval nozzle (3) situated upstream.

**3.** Fluidized bed reactor according to Claim 1, comprising at least one group of openings (2) in the reactor base, comprising at least two openings (2), wherein a Laval nozzle (3) is situated upstream of the at least one group of openings (2) in each case.

**4.** Fluidized bed reactor according to Claim 1, comprising at least one group of openings (2) in the reactor base, comprising in each case at least two openings (2), wherein in each case one Laval nozzle (3) is situated upstream of each opening (2), in such a manner that at least one group of Laval nozzles (3) comprising in each case at least two Laval nozzles (3) results, wherein in each case one Laval nozzle (3) is connected upstream of each at least one group of Laval nozzles (3).

**5.** Fluidized bed reactor according to Claim 1, wherein the at least one opening (2) in the reactor base upstream of which a Laval nozzle (3) is situated is a gas distributor device (7).

**6.** Fluidized bed reactor according to any one of Claims 1 to 5, wherein the at least one opening (2) in the reactor base upstream of which a Laval nozzle (3) is situated is a hole in the base plate, a valve, or a nozzle.

**7.** Method for producing granular polysilicon in a fluidized bed reactor, which comprises fluidizing silicon particles by means of a fluidizing gas that is fed via at least one opening in the reactor base of the fluidized bed reactor in a fluidized bed (1) which is heated via a heating device to a temperature of 850-1200°C, addition of a silicon-containing reaction gas which is fed via at least one opening (2) in the reactor base of the fluidized bed reactor, and deposition of silicon on the silicon particles, wherein at least one mass stream (4) of fluidizing gas or reaction gas that is fed is expanded supercritically, wherein a Laval nozzle (3) is situated upstream of at least one of the openings (2) in the reactor base in order to expand supercritically the at least one mass stream (4) that is fed, by overpressure prevailing in the Laval nozzle (3).

**8.** Method according to Claim 7, wherein the fluidizing gas is $H_2$ and the silicon-containing reaction gas is TCS.

**9.** Method according to either of Claims 7 and 8, wherein a fluidized bed reactor according to any one of Claims 1 to 6 is used.

**Revendications**

**1.** Réacteur à lit fluidisé destiné à la production de polysilicium granulaire, comprenant un récipient avec un tube réacteur interne pour un lit fluidisé (1) avec du polysilicium granulaire et un fond de réacteur, un dispositif de chauffage destiné au chauffage du lit fluidisé dans le tube réacteur interne, au moins un orifice dans le fond du réacteur pour l'introduction de gaz de fluidisation ainsi qu'au moins un orifice (2) dans le fond du réacteur pour l'introduction de gaz de réaction, un dispositif pour l'évacuation de gaz rejeté du réacteur, un dispositif d'alimentation pour l'introduction de particules de silicium, ainsi qu'un conduit de décharge pour le polysilicium granulaire, une buse de Laval (3), appropriée à l'expansion en état supercritique d'au moins un courant de masse (4) introduit, étant placée devant au moins l'un des orifices dans le fond du réacteur, à l'extérieur du tube réacteur interne.

**2.** Réacteur à lit fluidisé selon la revendication 1, comprenant au moins deux orifices (2) dans le fond du réacteur, avec chacun une buse de Laval (3) placée devant.

**3.** Réacteur à lit fluidisé selon la revendication 1, comprenant au moins un groupe d'orifices (2) dans le fond du réacteur, comprenant au moins deux orifices (2), chaque fois une buse de Laval (3) étant placée devant ledit au moins un groupe d'orifices (2).

**4.** Réacteur à lit fluidisé selon la revendication 1, comprenant au moins un groupe d'orifices (2) dans le fond du réacteur, comprenant chacun au moins deux orifices (2), une buse de Laval (3) étant chaque fois placée devant chaque orifice (2), de sorte qu'il en résulte au moins un groupe de buses de Laval (3), comprenant chaque fois au moins deux buses de Laval (3), une buse de Laval (3) étant chaque fois placée en amont de chaque fois au moins un groupe de buses de Laval (3).

**5.** Réacteur à lit fluidisé selon la revendication 1, dans lequel pour ce qui est dudit au moins un orifice (2) dans le fond du réacteur, devant lequel est placée une buse de Laval (3), il s'agit d'un dispositif distributeur de gaz (7).

**6.** Réacteur à lit fluidisé selon l'une quelconque des revendications 1 à 5, dans lequel pour ce qui est dudit au moins un orifice (2) dans le fond du réacteur, devant lequel est placée une buse de Laval (3), il s'agit d'un trou dans la plaque de fond, d'une soupape ou d'une buse.

**7.** Procédé pour la production de polysilicium granulaire dans un réacteur à lit fluidisé, comprenant la fluidisation de particules de silicium au moyen d'un gaz de fluidisation introduit, par au moins un orifice dans le fond de réacteur du réacteur à lit fluidisé, dans un lit fluidisé (1) qui est chauffé jusqu'à une température de 850 - 1 200 °C par un dispositif de chauffage, l'addition d'un gaz de réaction contenant du silicium, qui est envoyé par au moins un orifice (2) dans le fond de réacteur du réacteur à lit fluidisé, et le dépôt de silicium sur les particules de silicium, dans lequel au moins un flux massique (4) introduit de gaz de fluidisation ou de gaz de réaction est expansé en état supercritique, dans lequel une buse de Laval (3) est placée devant au moins l'un des orifices (2) dans le fond du réacteur, pour l'expansion en état supercritique dudit au moins un flux massique (4) introduit, par le fait qu'une surpression règne dans la buse de Laval (3).

**8.** Procédé selon la revendication 7, dans lequel pour ce qui est du gaz de fluidisation il s'agit de $H_2$ et pour ce qui est du gaz de réaction contenant du silicium il s'agit de TCS.

**9.** Procédé selon l'une quelconque des revendications 7 et 8, dans lequel on utilise un réacteur à lit fluidisé selon l'une quelconque des revendications 1 à 6.

Fig. 1

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4786477 A
- US 7922990 B2
- US 20080299291 A1
- US 7490785 B2
- US 7850102 B2